(19)

Europäisches Patentamt
European Patent Office
Office européen des brevets

(11) **EP 4 380 071 A2**

(12) **EUROPEAN PATENT APPLICATION**

(43) Date of publication:
**05.06.2024 Bulletin 2024/23**

(21) Application number: **23209640.4**

(22) Date of filing: **14.11.2023**

(51) International Patent Classification (IPC):
**H04B 7/06** (2006.01)    **H01Q 3/34** (2006.01)
**H04W 16/28** (2009.01)

(52) Cooperative Patent Classification (CPC):
**H04B 7/0617; H01Q 3/34; H04W 16/28**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.11.2022  FI 20226058**

(71) Applicant: **Nokia Solutions and Networks Oy 02610 Espoo (FI)**

(72) Inventor: **SAYGINER, Mustafa Madison (US)**

(74) Representative: **Nokia EPO representatives Nokia Technologies Oy Karakaari 7 02610 Espoo (FI)**

(54) **ADDRESSING FOR INTEGRATED CIRCUITS**

(57) Disclosed is a method comprising determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.

**FIG. 4B**

EP 4 380 071 A2

**Description**

**TECHNICAL FIELD**

The following example embodiments relate to integrated circuits.

**BACKGROUND**

Wireless communication networks and many other technologies, such as radar, may utilize active phased array antennas. For example, active phased array antennas may be used in communication systems such as next-generation satellite communication (SATCOM) and mm-wave fifth generation (5G) and sixth generation (6G) communication systems. An active phased array antenna may include a plurality of antenna elements arranged on a carrier board, e.g., a printed circuit board (PCB), in 1- or 2-dimensional (2-D) configuration and may enable beamforming, beam steering, and other signal operations and manipulations. Each antenna element may be powered and/or controlled via an active element, e.g., a channel. A plurality of active elements may be combined to form a beamformer integrated circuit having a digital control interface.

**SUMMARY**

The scope of protection sought for various embodiments of the disclosure is set out by the independent claims. The example embodiments and features, if any, described in this specification that do not fall under the scope of the independent claims are to be interpreted as examples useful for understanding various embodiments of the disclosure.
According to a first aspect there is provided an apparatus comprising means for: determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.
In some example embodiments according to the first aspect, the means comprises at least one processor, and at least one memory, including a computer program code, wherein the at least one memory and the computer program code are configured, with the at least one processor, to cause the performance of the apparatus.
According to a second aspect there is provided an apparatus comprising at least one processor, and at least one memory including a computer program code, wherein the at least one memory and the computer program code are configured, with the at least one processor, to cause the apparatus to: determine that a signal is to be provided to a beamformer integrated circuit using a control interface associated with the beamformer integrated circuit, identify, within the at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and provide the signal to the beamformer integrated circuit using the unique address.
According to a third aspect there is provided a method comprising: determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.
In some example embodiments according to the third aspect, the method is a computer-implemented method.
According to a fourth aspect there is provided a computer program comprising instructions for causing an apparatus to perform at least the following: determine that a signal is to be provided to a beamformer integrated circuit using a control interface associated with the beamformer integrated circuit, identify, within the at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and provide the signal to the beamformer integrated circuit using the unique address.

According to a fifth aspect there is provided a computer program comprising instructions stored thereon for performing at least the following: determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.

According to a sixth aspect there is provided a non-transitory computer readable medium comprising program instructions for causing an apparatus to perform at least the following: determine that a signal is to be provided to a beamformer integrated circuit using a control interface associated with the beamformer integrated circuit, identify, within the at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and provide the signal to the beamformer integrated circuit using the unique address.

According to a seventh aspect there is provided a non-transitory computer readable medium comprising program instructions stored thereon for performing at least the following: determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.

According to an eighth aspect there is provided a computer readable medium comprising program instructions stored thereon for performing at least the following: determining that a signal is to be provided to a beamformer integrated circuit using a control interface associated with the beamformer integrated circuit, identifying, within, at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address, and providing the signal to the beamformer integrated circuit using the unique address.

According to a ninth aspect there is provided a system for an active phased array antenna, the system comprising, a plurality of antenna elements, at least one beamformer integrated circuit electrically coupled to at least one of the plurality of antenna elements and configured to control operation thereof, wherein the at least one beamformer integrated circuit includes at least one address pin being in one set state of at least three available set states, and a main controller electrically coupled to the at least one beamformer integrated circuit and configured to communicate to the at least one beamformer integrated circuit to control operation thereof, wherein the main controller communicates with the at least one beamformer integrated circuit using a unique address of the at least one beamformer integrated circuit, wherein the unique address is defined, at least partly, by the one set state of the at least one address pin of the at least one beamformer integrated circuit.

**BRIEF DESCRIPTION OF DRAWINGS**

In the following, the invention will be described in greater detail with reference to the embodiments and the accompanying drawings, in which

FIG. 1A illustrates an example phased array layout;
FIG. 1B illustrates another example phased array layout;
FIG. 1C illustrates an example beamformer integrated circuit in accordance with the present disclosure;
FIG. 2A illustrates an example phased array control implementation in accordance with the present disclosure;

FIG. 2B illustrates an example digital control interface layout in accordance with the present disclosure;
FIG. 3 illustrates an example circuit diagram and corresponding input and output voltage states;
FIG. 4A illustrates another example circuit diagram and corresponding input and output voltage states;
FIG. 4B illustrates an example electric circuit diagram in accordance with the present disclosure;
FIG. 5A-5D illustrates example electric circuit diagrams for a plurality of address pin states;
FIG. 6 illustrates example voltage levels for the address pin states of FIGS. 5A-5D;
FIG. 7 illustrates an example circuit diagram in accordance with the present disclosure; and
FIG. 8 illustrates an example embodiment of an apparatus.

## DETAILED DESCRIPTION

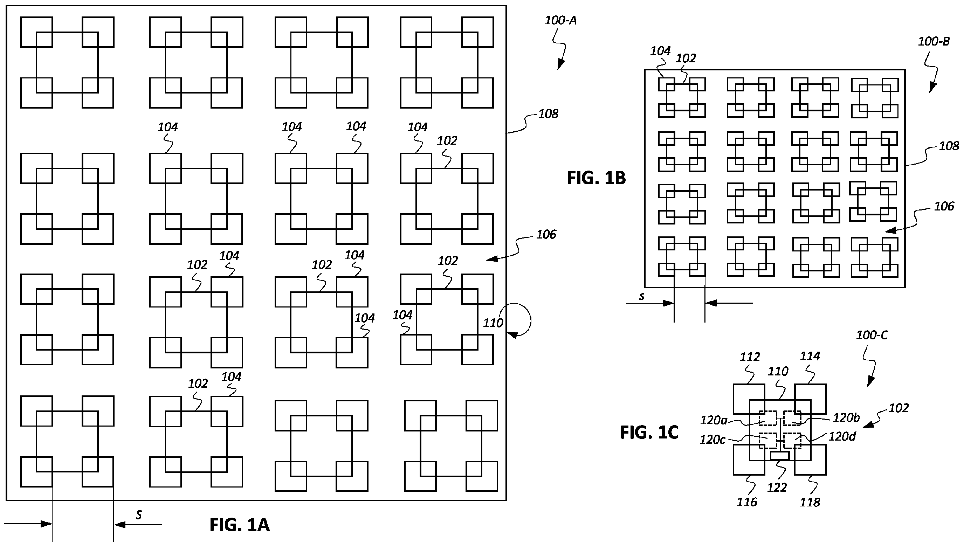

FIGS. 1A and 1B illustrate example active phased array antennas 100-A and 100-B. Each of the active phased array antennas 100-A and 100-B includes a plurality of beamformer integrated circuits 102 and a plurality of antenna elements 104. In one example, a plurality of beamformer integrated circuits 102 of a given active phased array antenna 100 may be distributed along a first side 106 of a carrier board 108 and may be aligned uniformly with respect to corresponding positions of one or more antenna elements 104 positioned on a second side 110 of the carrier board 108, where the second side 110 is opposite the first side 106.

A distance (also referred to as "spacing") between a given pair of antenna elements 104 disposed adjacent one another may be defined based on one or more operating parameters of the antenna elements, such as, for example, operating frequency and corresponding wavelength. The spacing requirements may apply to prevent or minimize occurrence of grating lobes and other undesirable distortions of the signals transmitted and/or received by the antenna elements 104. In an example, a spacing between a pair of adjacent antenna elements 104 may not exceed one-half of the wavelength $\lambda$, or $\lambda/2$, where wavelength $\lambda$ may be defined as being inversely proportional to operating frequency f, i.e., $\lambda=1/f$.

Given this operating principle, it follows that the higher the operating frequency of the active phased array antenna, the tighter is the spacing between the antenna elements of that active phased array antenna. With reference to FIGS. 1A and 1B, the first active phased array antenna 100-A may be configured to operate at a first frequency and the second active phased array antenna 100-B may be configured to operate at a second frequency, where the second frequency is greater than the first frequency. As just one example, the first frequency may be 28 GHz and the second frequency may be 140 GHz. Accordingly, as discussed above, a first spacing $S$ between antenna elements 104 of the first active phased array antenna 100-A configured to operate at the first (smaller) frequency is relatively large, whereas a second spacing s between the antenna elements 104 of the second active phased array antenna 100-B configured to operate at the second (larger) frequency is noticeably smaller than the first spacing $S$.

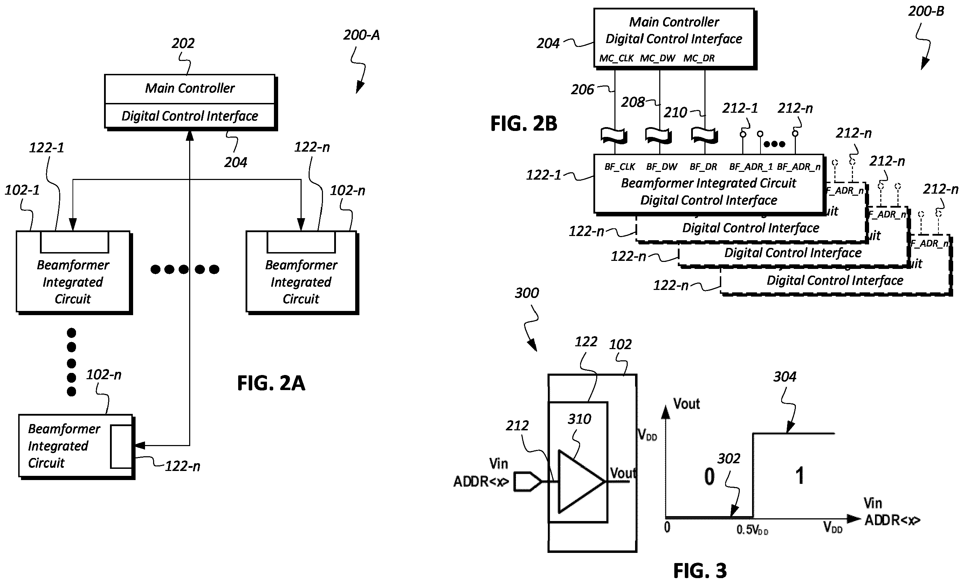

FIG. 1C illustrates an example arrangement 100-C of the beamformer integrated circuit 102 with respect to a plurality of antenna elements 112, 114, 116, and 118. In some instances, the beamformer integrated circuit 102 may be a radio frequency integrated circuit (RFIC) and may include a chip body 110 and a plurality of active channels 120*a*, 120*b*, 120*c*, and 120*d*, where each channel 120*a*-120*d* is electrically coupled to a different one of the antennas elements 112, 114, 116, and 118. As described in reference to at least FIGS. 2A-2B, the beamformer integrated circuit 102 may include a digital control interface 122 via which the control signals arrive and leave the beamformer integrated circuit 102.

The beamformer integrated circuit 102 may be configured to control operation of one or more antenna elements 112, 114, 116, and 118 using a corresponding one of the channels 120*a*-120*d*, based on the received signals or commands. The received signals or commands may be for example related to beamforming or beam steering operations that are to be performed. While a four-channel beamformer integrated circuit 102 is described in reference to FIGS. 1A-1C, the present disclosure is not limited thereto. A number of channels in a given beamformer integrated circuit 102 may be more or fewer than 4, such as, for example, 2, 12, 16, or any other number.

In order to establish an efficient connection between the channels 120*a*-120*d* and the corresponding antenna elements 112, 114, 116, and 118, a size of the beamformer integrated circuit 102 may decrease as the spacing between the antenna elements 112, 114, 116, and 118 in high-frequency phased arrays (e.g., active phased array antennas operating at frequencies greater than 100 GHz) becomes smaller. This phenomenon may be observed in corresponding sizes of the beamformer integrated circuits 102 of the active phased array antennas 100-A and 100-B described in reference to at least FIGS. 1A and 1B.

As illustrated in FIG. 2A, an example active phased array antenna 200-A may include a main controller 202 communicatively coupled to a plurality of beamformer integrated circuits 102-1 to 102-n (such as beamformer integrated circuits 102 described in reference to FIGS. 1A-1C) and configured to transmit and receive signals therefrom. Yet, it is to be noted that in some alternative examples the main controller, which may also be understood as one or more processors, may be connected to the active phase array antenna, and thereby to the plurality of beamformer integrated circuits, instead of being included in it. When the main processor is communicatively coupled to, or connected to the plurality of beamformer integrated circuits, the main processor may be considered to have access to the plurality of beamformer integrated circuits and thus be able to control them for example by providing a signal, such as a control signal. In some instances, prior to or shortly after being positioned on the carrier board 108, the beamformer integrated circuits 102-1 to 102-n of the phased array 200-A may be digitally programmed, e.g., via an external controller, such as a modem or a computer, to recognize signals or commands from the main controller 202. In some instances, a physical layout of the integrated circuits 102 on the carrier board 108 and/or pre-operational programming may include ensuring that each beamformer integrated circuit 102 is configured to be aware of (or to know) its own unique address, such that each beamformer integrated circuit 102 recognizes signals or commands directed by the main controller 202 to that particular beamformer integrated circuit 102.

In some instances, the main controller 202 includes a main controller digital control interface 204 that may be communicatively coupled to corresponding digital control interfaces 122-1 to 122-n of each of the beamformer integrated circuits 102-1 to 102-n. The beamformer integrated circuit 102 may be configured to use the digital control interface 122 to transmit signals to and receive signals from the main controller 202, where the transmitted and/or received signals may be related to controlling operation of the antenna elements 112, 114, 116, and 118 by the beamformer integrated circuit 102.

FIG. 2B illustrates an example implementation 200-B of a communicative connection between the main controller 202 and a plurality of integrated circuits 102-1 to 102-n in accordance with the present disclosure. In one example, the digital control interface 204 of the main controller 202 and/or the digital control interface 112 of the beamformer integrated circuit 102 may be implemented as a serial peripheral interface (SPI). To that end, the digital control interface 204 of the main controller 202 may interface with the digital control interface 112 of the beamformer integrated circuit 102 via a corresponding one of a "clock" pin 206, a "data write" pin 208, and a "data read" pin 210.

The corresponding digital control interface 112 of each beamformer integrated circuit 102 may include one or more address pins 212-1 to 212-n. The one or more address pins 212-1 to 212-n of each beamformer integrated circuit 102 may be configured to be in a predefined electrical and/or electronic state, including, but not limited to, a state that is analog, digital, and/or logical in nature. For example, the state of an address pin may correspond to an input voltage provided to the address pin. In one example, the predefined state of each address pin 212 may be set during manufacturing or printing of an active phased array antenna electrical circuit on the carrier board 108. Taken collectively, the states of the one or more address pins 212-1 to 212-n of a given beamformer integrated circuit 102 may be indicative of a unique address associated with that beamformer integrated circuit 102. The unique address of the beamformer integrated circuit may be understood as an address that is used for identifying the beamformer integrated circuit from a plurality of other beamformer circuits that are comprised in the same system, for example, in the same active phased array antenna system.

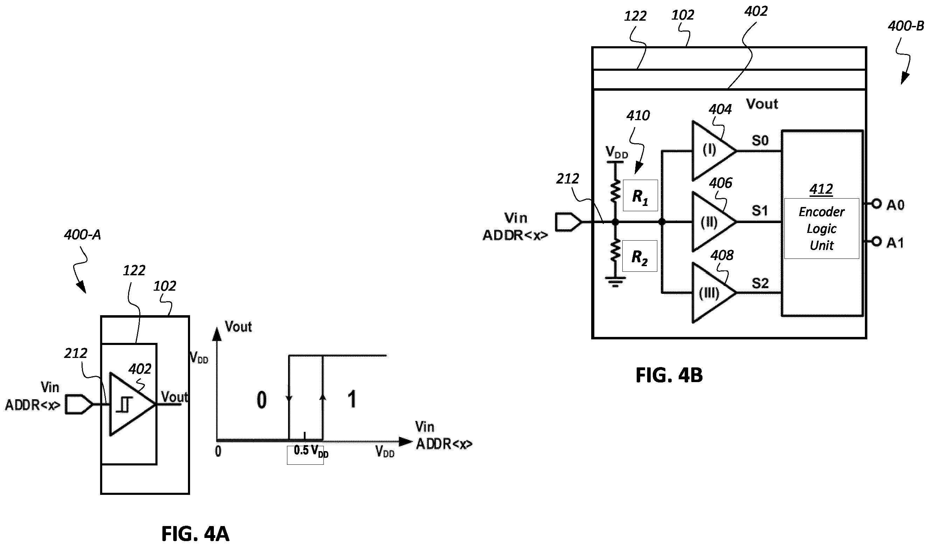

Accordingly, a given beamformer integrated circuit 102 uses, at least in some examples, the predefined state of its single address pin 212 (or the predefined states of a plurality of its address pins 212 considered collectively) to determine whether a signal being broadcasted by the main controller 202 is directed to that beamformer integrated circuit 102. The main controller 202 may be configured to include in a broadcasted data frame a unique address associated with a specific beamformer integrated circuit 102 that is the intended recipient of the broadcasted data frame. As described in reference to at least FIGS. 3 and 4, a number of address pins 212 necessary, for providing unique addresses, in each beamformer integrated circuit 102 of a given active phased array antenna may depend on a number of beamformer integrated circuits 102 that the main controller 202 controls.

FIG. 3 illustrates an example two-level binary logic addressing approach 300 for the beamformer integrated circuit 102. The address pin 212 of the digital control interface 122 may be electrically coupled to a logic buffer 310. In an example, the address pin 212 may be set to be electrically pulled "low", e.g., set to be electrically pulled to ground (GND), to correspond to a set state of the address pin 212 as being a low state 302. The address pin 212 of the digital control interface 122 may be set to be electrically pulled "high", e.g., electrically pulled to a predefined voltage $V_{DD}$, to correspond to a set state of the address pin 212 as being a high state 304.

In an example, the buffer 310 may be configured to interpret the set pulled "low" state of the address pin 212 as corresponding to a logic zero (0) value and interpret the set pulled "high" state of that address pin 212 as corresponding to a logic one (1) value. Moreover, where the set state of its single address pin 212 corresponds to a logic zero (0) value, the unique address of that beamformer integrated circuit 102 may be a digital value zero (0) and, where the set state of its single address pin 212 corresponds to a logic one (1) value, the unique address of that beamformer integrated circuit 102 may be a digital value one (1).

By way of an example, the beamforming integrated circuit 102 including a first address pin 212-1 and a second address pin 212-2 may have a unique address "01", if the set state of the first address pin 212-1, e.g., according to the buffer 310, corresponds to a logic zero (0) value and the set state of the second address pin 212-2 corresponds to a logic one (1) value. It is to be noted that in general, the set state may be understood to correspond to an input voltage provided to an address pin. The different input voltages that may be provided to the address pin may be considered as set states that are available to the address pin. In case of logic zero and logic one for example, the address pin has thus two set states available for it. As still another example, the beamforming integrated circuit 102 including a first address pin 212-1, a second address pin 212-2, and a third address pin 212-3 may have a unique address "110", if, e.g., according to the buffer 310, the set state of the first address pin 212-1 corresponds to a logic one (1) value, the set state of the second address pin 212-2 corresponds to a logic one (1) value, and the set state of the third address pin 212-3 correspond to a logic zero (0) value.

Thus, using the two-level binary logic addressing approach 300, where the buffer 310 discerns only two unique set states (a "high" state and a "low" state) of the address pin 212, generating a number $N$ of unique addresses requires using a number $x$ of hard-wired address pins 212, such that

$$N = 2^x. \tag{1}$$

Accordingly, for an example phased array antenna system including 64 beamformer integrated circuits 104, solving for $x$ in $64 = 2^x$ results in $x = 6$, where $x$ is indicative of a number of hard-wired address pins 212. In other words, the two-level binary logic approach provides using no fewer than six (6) address pins 212 on each beamformer integrated circuit 102 to generate 64 unique 6-bit addresses. As another example, since $1024 = 2^x$ results in $x = 10$, the two-level binary logic approach 300 may require each beamformer integrated circuit 102 of a phased array having 1024 beamformer integrated circuits 102 to have at least 10 hard-wired address pins 212.

A tighter spacing between the antenna elements and a demand for a smaller overall footprint of the active phased array antennas may cause less space to be available for pads of the beamformer integrated circuits 102. Moreover, a number of beamformer integrated circuits 102 used in a given active phased array antenna may be increasing and, in some applications, may be in the thousands. An addressing methodology in accordance with the present disclosure that minimizes a number of address pins 212 necessary to communicate with a predefined number of beamformer integrated circuits using unique beamformer integrated circuit addresses may increase efficiency and dependability of large active phased array antennas. Thus, for one individual address pin, a larger address space than binary "0" and "1", may be available.

As described in reference to at least FIGS. 4A and 4B, main controllers 202 and beamformer integrated circuits 102 of a given active phased array antenna may be configured to use an addressing scheme, where a number of unique addresses $N$ with respect to a number of address pins $x$ necessary in each beamformer integrated circuit 102 is defined using Equation (2) such that

$$N = M^x, \tag{2}$$

where M is indicative of a number of detectable set states of the address pin 212. Under the addressing methodology of the present disclosure, in an active phased array antenna having beamformer integrated circuits 102 configured to detect three (3) set states of the address pins 212 (i.e., $M=3$), 64 beamformer integrated circuits 102, each having only three (3) hard-wired address pins, may be uniquely addressed by the main controller 202.

As another example, the addressing methodology of the present disclosure allows uniquely addressing 256 beamformer integrated circuits 102 using only four (4) hard-wired address pins on each beamformer integrated circuit 102, where each circuit 102 is configured to detect 4 set states of each of the address pins 212 (i.e., $M=4$). Put another way, a number of address pins required to address 256 beamformer integrated circuits 102 under the addressing methodology of the present disclosure may be four (4), or one-half the number of pins necessary to address the same number of beamformer integrated circuits 102 using a two-level binary addressing system.

FIG. 4A illustrates an example addressing approach 400-A in accordance with the present disclosure. In an example, an electrical circuit 402 having one or more electric circuit components may be configured to detect a number $M$ of set states of the address pins 212, where $M$ is greater than two. In other words, the electrical circuit 402 may be configured to discern set states of the address pin 212 in addition to a high state and a low state detected using the two-level binary approach. Thus, the address pin 212 in this example has $M$ set states that are available to it.

In some instances, the available voltage range between and including $V_{GND}$, or 0 V, and $V_{DD}$ may be divided into $M$ different levels, such as, for example, but not limited to, three (3) levels or four (4) levels. The electrical circuit 402 may be configured to discern corresponding set states of each of the address pin 212 as being one of either 3 or 4 possible set states. As just one example, the electrical circuit 310 may be configured to detect a different set state of the address pin 212 when the input voltage $V_{IN}$ is between $V_{GND}$ and $0.5^*V_{DD}$. As another example, the electrical circuit 310 may be configured to detect a different set state of the address pin 212 when the input voltage $V_{IN}$ is between $0.5^*V_{DD}$ and $V_{DD}$.

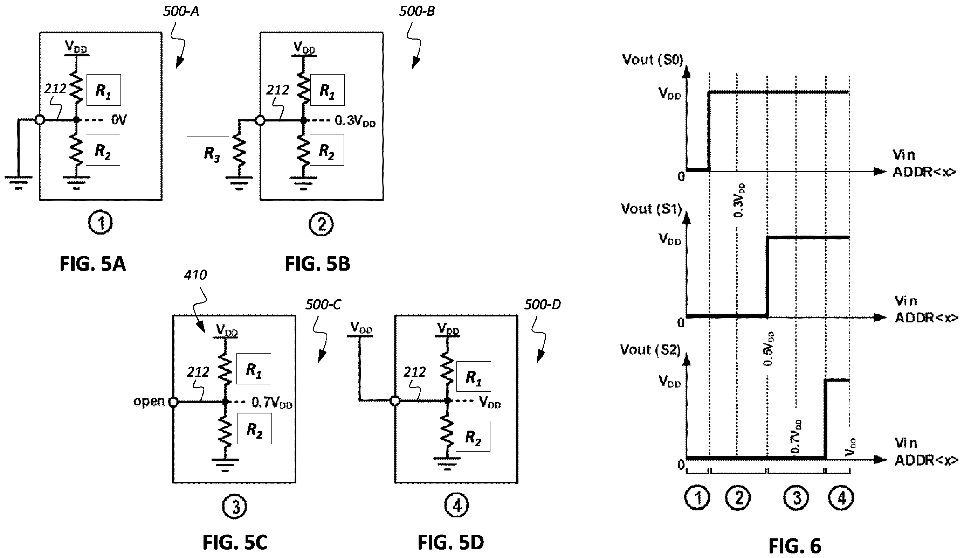

FIG. 4B illustrates an example implementation 400-B of the electrical circuit 402 configured to detect a number of $M$ of unique set states, where $M$ is greater than two. The electrical circuit 402 includes a plurality of logic buffers 404, 406, 408, such as non-Schmitt or Schmitt type buffers, electrically coupled to an address pin 212. In response to detecting a given threshold voltage at the address pin 212, each of logic buffers 404, 406, 408 may be configured to output a predefined logic state that may be same as or different from logic states of the other logic buffers 404, 406, 408. A voltage divider 410 coupled to the address pin 212 at the input to the buffers 404, 406, 408 may include a first resistor $R_1$ and a second resistor $R_2$. As described in reference to FIGS. 5C and 6, the voltage divider 410 may be configured to cause a voltage level of the address pin 212 to be a predefined voltage in response to the address pin 212 being left electrically open, i.e., being allowed to float. Thus, the logic buffers 404, 406, 408 receive the same input voltage as their inputs are connected to the same address pin 212.

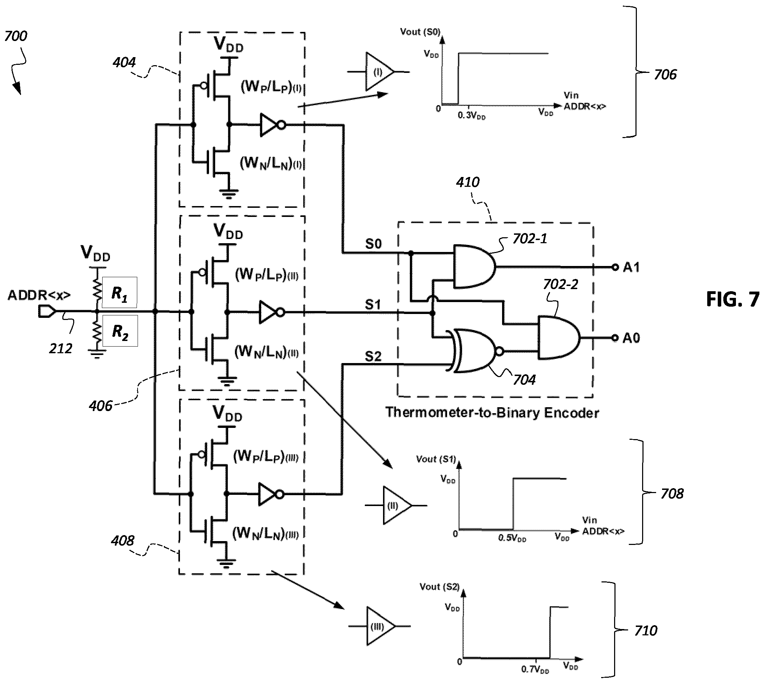

In response to detecting one or more threshold voltage levels at the address pin 212, the buffers 404, 406, and 408 may generate output signals *S0, S1*, and *S2*, respectively. The output signals *S0, S1*, and *S2* may serve as input to an encoder logic unit 412 that, in turn, generates output signals *A0* and *A1*. The output signals *A0* and *A1* then provide, at least partly, the unique address associated with the address pin 212. As described for example in reference to FIG. 7, the encoder logic unit 412 may be configured to interpret logic values output by the buffers 404, 406, 408 as signals *S0, S1*, and *S2* and may generate output signals *A0* and *A1* responsive thereto.

It is to be noted that in case a beamformer integrated circuit has a unique address that is provided by two address pins, thus there being an additional address pin in addition to the address pin 212, the additional address pin is coupled to logical buffers in the same manner as the address pin 212 is connected to the logic buffers 404, 406, 408. The logic buffers that receive their input from the additional address pin can also have a structure, which may be understood as hardware implementation, to those of the logic buffers 404, 406, 408. The same principle may apply also in case there are n additional address pins used for the unique address.

FIGS. 5A, 5B, 5C, and 5D illustrate example circuits 500-A, 500-B, 500-C, and 500-D, each representative of a different one of a plurality of possible set states of the address pin 212 and a voltage level detected by the buffers 404, 406, and 408 during that set state. The first circuit 500-A illustrates a first set state of the address pin 212, e.g., the address pin 212 being set to be pulled low, e.g., to GND, such that the buffers 404, 406, and 408 detect a first input voltage level. In an example, the first input voltage level may be approximately 0 V. In response to detecting the first input voltage level, each of the buffers 404, 406, and 408 may be configured to output a logic state 0, as illustrated, for example, in FIG. 6 and Table 1.

The second circuit 500-B illustrates a second set state of the address pin 212, e.g., the address pin 212 being set to be electrically coupled to a third resistor $R_3$, such that the buffers 404, 406, and 408 detect a second input voltage level. In an example, the second input voltage level may be approximately $0.3*V_{DD}$. In response to detecting the second input voltage level, the first buffer 404 may be configured to output a logic state 1, while the second buffer 406 and the third buffer 408 may be configured to output a logic state 0 at outputs *S0, S1,* and *S2*, respectively, as illustrated, for example, in FIG. 6 and Table 1.

The third circuit 500-C illustrates a third set state of the address pin 212, e.g., the address pin 212 being set to be left open, such that the voltage divider 410 causes the buffers 404, 406, and 408 to detect a third input voltage level. In an example, the third input voltage level may be approximately $0.7*V_{DD}$. In response to detecting the third input voltage, the first buffer 404 and the second buffer 406 may be configured to output a logic state 1 at outputs *S0* and *S1*, respectively, while the third buffer 408 may be configured to output a logic state 0 at output *S2*, as illustrated, for example, in FIG. 6 and Table 1.

The fourth circuit 500-D illustrates a fourth set state of the address pin 212, e.g., voltage $V_{DD}$ being applied to the address pin 212, such that the buffers 404, 406, and 408 detect a fourth input voltage level. In an example, the fourth input voltage level may be approximately $V_{DD}$. In response to detecting the fourth input voltage, each of the buffers 404, 406, and 408 may be configured to output a logic state 1 at outputs *S0, S1,* and *S2*, respectively, as illustrated, for example, in FIG. 6 and Table 1.

**Table 1**

| Input States | ADDR<x> (Vin) | Comment | S2 | S1 | S0 | A1 | A0 |
|---|---|---|---|---|---|---|---|
| ① | Tied to GND | Logic-low input | 0 | 0 | 0 | 0 | 0 |
| ② | Tied to $R_3$ | Pull-down to GND via external resistor | 0 | 0 | 1 | 0 | 1 |
| ③ | Left open | Not connected | 0 | 1 | 1 | 1 | 0 |
| ④ | Tied to $V_{DD}$ | Logic-high input | 1 | 1 | 1 | 1 | 1 |

FIG. 7 illustrates an example circuit diagram 700 for implementing the addressing methodology in accordance with the present disclosure. The encoder logic unit 410 may be configured to detect the output signals *S0, S1, S2* of the logic buffers 404, 406, 408, respectively, in thermometer code and may encode the detected thermometer code into two-bit binary code using encoder logic. In one example, the encoder 410 includes first and second logic AND gates 702-1, 702-2 and a logic XNOR gate 704. The logic AND gates 702-1, 702-2 and the logic XNOR gate 704 may be configured to generate the output logic states based on the output signals *S0, S1*, and *S2* of the buffers 404, 406, and 408.

In particular, each of the logic AND gates 702-1, 702-2 may be configured to execute a logical conjunction operation, such that the logic AND gate outputs a high state (1) only if all inputs to that logic AND gate are high (1). Further, the logic XNOR gate 704 may be configured to execute a logical connective operation, such that the logic XNOR gate 704 outputs a high state (1) if all inputs to the XNOR gate 704 are the same (i.e., all inputs are high (1) or all inputs are low (0)) and outputs a low state (0) if a state of at least one input to the XNOR gate 704 is different from that of the other inputs.

In an example, a state of an output signal *A1* of the encoder logic unit 410 may be based on a logic AND operation performed on the output signals *S0* and *S1* by the logic AND gate 702-1. As another example, a state of the output signal *A0* of the encoder logic unit 410 may be based on a logic AND operation performed, by the logic AND gate 702-2, on the output signal *S0* and a result of a logic XNOR operation performed on the output signals *S2* and *S1* by the logic XNOR gate 704.

The example implementations described above may have several benefits. The hard-wired addressing approach of the present disclosure is platform-independent and may be implemented in any digital control interface configured to provide control signals to the integrated circuits. Further, using the floating input state as a third state in addition to logic low and logic high states, a single pin may be configured to address three beamformer integrated circuits without using any additional external components. Still further, by adding a single value ($R_3$ = 1.58R while $R_1$ = 3R and $R_2$ = 7R) resistor, a fourth input state may be introduced thereby increasing the number of beamformer integrated circuits addressable using a single address pin to four.

Put another way, the number of integrated circuits that may be addressed using a predefined number of hard-wired address pins may be doubled. Table 2 below illustrates the number of addressable beamformer integrated circuits using a predefined number of hard-wired address pins in a phased array having a number of detectable states *M*=2, *M*=3, and *M*=4. As such, the number of addressable beamformer integrated circuits for *x* address pins is defined as $M^x$, where *M* is a design parameter. It is to be noted that *M* may also be greater than four with additional logic buffers configured to change states in response to detecting additional predefined threshold voltage levels.

**Table 2**

| Number of Hard-wired Address Pins Used (x) ADDR< (x-1):0 > | Hard-wired Address (M=2) ($2^x$) | Hard-wired Addressing (M=3) Without Additional Board Components ($3^x$) | Hard-wired Addressing (M=4) With External Board Resistor ($4^x$) |
|---|---|---|---|
| 2 | 4 | 8 | 16 |
| 4 | 16 | 81 | 256 |
| 6 | 64 | 729 | 4096 |
| 8 | 256 | 6561 | 65K |
| 10 | 1024 | 59K | 1M |
| 12 | 4096 | 0.53M | 16M |

The examples introduced above may also have the benefit of allowing efficient design of very large active phased array antenna systems, such as active phased array antennas operating at frequencies >100 GHz, that include a large number of very small beamformer integrated circuits that have limited available pad space. Further, adding buffer circuits and encoder logic may be executed without occupying additional area in silicon. Moreover, the example embodiment described above may be compatible with control interfaces using two-level binary logic.

The above embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments.

As used in this application, the term 'circuitry' refers to all of the following: (a) hardware-only circuit implementations, such as implementations in only analog and/or digital circuitry, and (b) combinations of circuits and software (and/or firmware), such as (as applicable): (i) a combination of processor(s) or (ii) portions of processor(s)/software including digital signal processor(s), software, and memory(ies) that work together to cause an apparatus to perform various functions, and (c) circuits, such as a microprocessor(s) or a portion of a microprocessor(s), that require software or firmware for operation, even if the software or firmware is not physically present. This definition of 'circuitry' applies to all uses of this term in this application. As a further example, as used in this application, the term 'circuitry' would also cover an implementation of merely a processor (or multiple processors) or a portion of a processor and its (or their) accompanying software and/or firmware. The term 'circuitry' would also cover, for example and if applicable to the particular element, a baseband integrated circuit or applications processor integrated circuit for a mobile phone or a similar integrated circuit in a server, a cellular network device, or another network device. The above-described embodiments of the circuitry may also be considered as embodiments that provide means for carrying out the embodiments of the methods or processes described in this document.

The techniques and methods described herein may be implemented by various means. For example, these techniques may be implemented in hardware (one or more devices), firmware (one or more devices), software (one or more modules), or combinations thereof. For a hardware implementation, the apparatus(es) of embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, microcontrollers, microprocessors, other electronic units designed to perform the functions described herein, or a combination thereof. For firmware or software, the implementation can be carried out through modules of at least one chipset (e.g. procedures, functions, and so on) that perform the functions described herein. The software codes may be stored in a memory unit and executed by processors. The memory unit may be implemented within the processor or externally to the processor. In the latter case, it can be communicatively coupled to the processor via any suitable means. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

Embodiments described herein may be implemented in a communication system, such as in at least one of the following: Global System for Mobile Communications (GSM) or any other second generation cellular communication system, Universal Mobile Telecommunication System (UMTS, 3G) based on basic wideband-code division multiple access (W-CDMA), high-speed packet access (HSPA), Long Term Evolution (LTE), LTE-Advanced, a system based on IEEE 802.11 specifications, a system based on IEEE 802.15 specifications, and/or a fifth generation (5G), as well as 5G-Advanced (i.e. 3GPP NR Rel-18 and beyond), mobile or cellular communication system. Also, the embodiments described herein may be implemented in a 6G communication system as well. The embodiments are not, however, restricted to the system given as an example but a person skilled in the art may apply the solution to other communication systems provided with necessary properties.

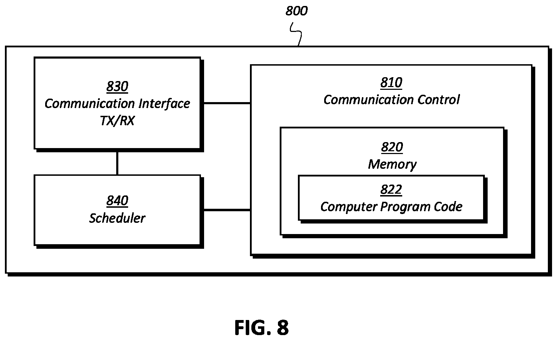

The apparatus 800 of FIG. 8 illustrates an example embodiment of an apparatus that may be an access node or be comprised in an access node and which may be used to provide a signal to a beamformer integrated circuit for performing beamforming or beam steering. The beamformer integrated circuit may also be comprised in the access node and may be addressed according to any of the examples described above. The apparatus may be, for example, a circuitry or a chipset applicable to an access node to realize the described embodiments. The apparatus 800 may be an electronic device comprising one or more electronic circuitries. The apparatus 800 may comprise a communication control circuitry 800 such as at least one processor, and at least one memory 820 including a computer program code (software) 822 wherein the at least one memory and the computer program code (software) 822 are configured, with the at least one processor, to cause the apparatus 800 to carry out any one of the example embodiments of the access node described above.

The memory 820 may be implemented using any suitable data storage technology, such as semiconductor-based memory devices, flash memory, magnetic memory devices and systems, optical memory devices and systems, fixed memory and removable memory. The memory may comprise a configuration database for storing configuration data. For example, the configuration database may store current neighbour cell list, and, in some example embodiments, structures of the frames used in the detected neighbour cells. As another example, the memory 820 may store unique addresses of a plurality of beamformer integrated circuits.

The apparatus 800 may further comprise a communication interface 830 comprising hardware and/or software for realizing communication connectivity according to one or more communication protocols. The communication interface 830 may provide the apparatus with radio communication capabilities to communicate in the cellular communication system. The communication interface may, for example, provide a radio interface to terminal devices. The apparatus 800 may further comprise another interface towards a core network such as the network coordinator apparatus and/or to the access nodes of the cellular communication system. The apparatus 800 may further comprise a scheduler 840 that is configured to allocate resources.

Even though the invention has been described above with reference to example embodiments according to the accompanying drawings, it is clear that the invention is not restricted thereto but can be modified in several ways within the scope of the appended claims. Therefore, all words and expressions should be interpreted broadly and they are intended to illustrate, not to restrict, the embodiment. It will be obvious to a person skilled in the art that, as technology advances, the inventive concept can be implemented in various ways. Further, it is clear to a person skilled in the art that the described embodiments may, but are not required to, be combined with other embodiments in various ways.

**Claims**

1. A system for an active phased array antenna, the system comprising:

   a plurality of antenna elements;
   at least one beamformer integrated circuit electrically coupled to at least one of the plurality of antenna elements and configured to control operation thereof, wherein
   the at least one beamformer integrated circuit includes at least one address pin being in one set state of at least three available set states; and
   a main controller electrically coupled to the at least one beamformer integrated circuit and configured to communicate to the at least one beamformer integrated circuit to control operation thereof, wherein
   the main controller communicates with the at least one beamformer integrated circuit using a unique address of the at least one beamformer integrated circuit, wherein
   the unique address is defined, at least partly, by the one set state of the at least one address pin of the at least one beamformer integrated circuit.

2. The system according to claim 1, wherein the at least three available set states comprise at least one further available set state.

3. The system according to claim 1 or 2, wherein at least one of the at least three available set states corresponds to a first input voltage greater than zero (0) volts (V), at least one of the at least three available set states corresponds to an electrical ground, at least one of the at least three available set states corresponds to a second input voltage greater than 0 V and less than the first input voltage, and wherein, when the system is according to claim 2, the at least one further available set state corresponds to a third input voltage greater than 0 V and less than the second input voltage.

4. The system according to any previous claim, wherein the first set state corresponds to the first address pin being not connected or being pulled to the electrical ground voltage using an external resistor.

5. The system according to any previous claim, wherein the at least one address pin is electrically coupled to a first logic buffer, to a second logic buffer, and to a third logic buffer, and where the first, the second, and the third logic buffers receive, as an input, the one set state of the at least one address pin, and, based on the one set state, the first logical buffer provides a first output voltage, the second logic buffer provides a second output voltage, and the third logical buffer provides a third output voltage.

6. The system according to claim 5, wherein the first, the second, and the third output voltages are provided to a first logical encoder that provides the first unique address based on the first, the second, and the third output voltages.

7. The system according to any previous claim, wherein the at least one address pin further comprises at least one other address pin, wherein the at least one other address pin is in a corresponding set state of one of the at least three available set states, wherein the at least one other address pin is electrically coupled to a fourth logical buffer having a structure corresponding to that of the first logical buffer, a fifth logical buffer having a structure corresponding to that of the second logical buffer, and a sixth logical buffer having a structure corresponding to that of the third logical buffer, and wherein the fourth, the fifth, and the sixth logical buffers receive, as an input, the corresponding set state of the at least one other address pin, and, based on the corresponding set state, the fourth logical buffer provides a fourth output voltage, the fifth logical buffer provides a fifth output voltage, and the sixth logical buffer provides a sixth output voltage.

8. The system according to claim 7, wherein the fourth, the fifth, and the sixth output voltages are provided to a second logical encoder that provides the second unique address based on the fourth, the fifth, and the sixth output voltages.

9. The system according to claim 7 or 8, wherein the second set state corresponds to the second address pin being not connected or being pulled to a ground voltage using an external resistor.

10. The system according to any previous claim, wherein the system is comprised in an access node.

11. An apparatus comprising at least one processor, and at least one memory including computer program code, wherein the at least one memory and the computer program code are configured, with the at least one processor, to cause the apparatus to:

determine that a signal is to be provided to a beamformer integrated circuit using a control interface associated with the beamformer integrated circuit;

identify, within the at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address; and

provide the signal to the beamformer integrated circuit using the unique address.

12. An apparatus according to claim 11, wherein the at least three available set states comprise at least one further available set state.

13. An apparatus according to claim 11 or 12, wherein the signal is for performing at least one of beam forming and beam steering.

14. A method comprising:

determining that a signal is to be provided to a beamformer integrated circuit using a control interface associated with the beamformer integrated circuit;

identifying, within at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address; and

providing the signal to the beamformer integrated circuit using the unique address.

15. A computer program comprising instructions for causing an apparatus to perform at least the following:

determine that a signal is to be provided to a beamformer integrated circuit using a control interface associated with the beamformer integrated circuit;

identify, within the at least one memory, a unique address of the beamformer integrated circuit, wherein the beamformer integrated circuit is aware of own unique address based on a set state of an address pin of the beamformer integrated circuit, wherein the set state of the address pin is one of at least three available set states, the set state being provided as an input to three logical buffers electrically coupled to the beamformer integrated circuit, and outputs from the three logical buffers being combined using a logical encoder that generates the unique address; and

provide the signal to the beamformer integrated circuit using the unique address.

FIG. 1A

FIG. 1B

FIG. 1C

100-A

100-B

100-C

EP 4 380 071 A2

**FIG. 2A**

**FIG. 2B**

**FIG. 3**

13

**FIG. 4A**

**FIG. 4B**

EP 4 380 071 A2

500-A

$V_{DD}$

212

$R_1$

0V

$R_2$

①

**FIG. 5A**

500-B

$V_{DD}$

212

$R_1$

0.3$V_{DD}$

$R_3$

$R_2$

②

**FIG. 5B**

410

500-C

$V_{DD}$

212

$R_1$

open

0.7$V_{DD}$

$R_2$

③

**FIG. 5C**

500-D

$V_{DD}$

$V_{DD}$

212

$R_1$

$V_{DD}$

$R_2$

④

**FIG. 5D**

Vout (S0)

$V_{DD}$

0

Vin
ADDR<x>

Vout (S1)

0.3$V_{DD}$

$V_{DD}$

0

Vin
ADDR<x>

Vout (S2)

0.5$V_{DD}$

$V_{DD}$

0.7$V_{DD}$

$V_{DD}$

0

Vin
ADDR<x>

① ② ③ ④

**FIG. 6**

FIG. 7

**800**

**810**
**Communication Control**

**820**
**Memory**

**822**
**Computer Program Code**

**830**
**Communication Interface TX/RX**

**840**
**Scheduler**

**FIG. 8**